(19) Europäisches Patentamt
European Patent Office
Office européen des brevets

(11) Publication number: 0 112 649 B1

(12) # EUROPEAN PATENT SPECIFICATION

(45) Date of publication of patent specification: 26.10.88

(51) Int. Cl.$^4$: **C 30 B 29/28**, C 30 B 15/00, C 30 B 11/00

(21) Application number: 83307122.8

(22) Date of filing: 22.11.83

(54) **Process for making laser host garnet crystal material free of water and hydroxyl ion impurities.**

(30) Priority: 23.11.82 US 444033

(43) Date of publication of application: 04.07.84 Bulletin 84/27

(45) Publication of the grant of the patent: 26.10.88 Bulletin 88/43

(84) Designated Contracting States: CH DE FR GB IT LI NL SE

(56) References cited:
EP-A-0 030 170
EP-A-0 067 521

(73) Proprietor: UNION CARBIDE CORPORATION
39 Old Ridgebury Road
Danbury Connecticut 06817 (US)

(72) Inventor: Kokta, Milan R.
1906 S.E. 331 Avenue
Washougal Washington 98671 (US)
Inventor: De Lozier, Ben A.
14321 Ponderosa Pine Avenue
Vancouver Washington (US)

(74) Representative: McCall, John Douglas et al
W.P. THOMPSON & CO. Coopers Building
Church Street
Liverpool L1 3AB (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 112 649 B1

**Description**

This invention relates to laser host garnet crystal material, e.g., neodymium doped yttrium aluminum garnet, Nd:YAG crystal, for use in the manufacture of lasers. More particularly the present invention is directed to a process for making laser host garnet crystal material which is substantially free of water and hydroxyl ions.

Nd:YAG crystal material is well known as a laser host garnet crystal material and is manufactured commercially using the well known Czochralski technique to provide elongate boules of Nd:YAG crystal from which laser rods are obtained using coring and polishing practices known to the art. The unicrystalline Nd:YAG boule is obtained by a practice which involves the induction melting of an oxide charge, i.e., $Y_2O_3$, $Nd_2O_3$ and $Al_2O_3$ in a container in proportions to provide Nd:YAG, e.g., in accordance with the following formulation:

$$xNd_2O_3+(3-x)Y_2O_3+5Al_2O_3\rightarrow 2\{Nd_x\ Y_{3-x}\}Al_5O_{12}$$

With the mixture melted and the melt at a temperature in the range of 1945 to 1960°C an Nd:YAG seed crystal is immersed, rotated and withdrawn to "pull" a boule of Nd:YAG from the melt. The ambient atmosphere during heating to melting is commonly dry nitrogen containing up to 1200 ppm $O_2$. The boule obtained as above is subsequently cored and processed to obtain an Nd:YAG laser rod.

Another well known commercial practice for making Nd:YAG crystal material follows the known Bridgman technique of solidifying the melt in a container under vacuum conditions to obtain an Nd:YAG crystal which is subsequently cored and processed by known techniques to obtain a laser rod.

It is known in the art that Nd:YAG laser rods exhibit significantly less than theoretical lasing efficiency when such rods contain water and water-derived impurities, e.g., hydroxyl ions. U.S. Patent 4,315,832—R. C. Pastor and D. P. Devor discloses a technique to effect removal of such impurities from manufactured Nd:YAG laser rods utilizing an atomic oxygen treatment of the manufactured laser rods. This practice involves the post-manufacture handling and processing of laser rods and since the water-derived impurities to be removed originate in the starting materials, it is considered that it would be of substantial advantage to eliminate such impurities prior to laser rod manufacture. In the past it has been assumed that the water in the commercial grade oxides, i.e., $Nd_2O_3$, $Y_2O_3$ and $Al_2O_3$, used in the starting mixture (ranging from about 1 to 8% by weight in the aggregate) would be essentially completely driven-off in the course of raising the temperature of the mixture to the melting temperature, e.g., 1950°C over a period of one to two hours. It is now known that in spite of such thermal history, an amount of water-derived impurities, e.g., hydroxyl ions, is retained in the Nd:YAG crystal which is sufficient to significantly reduce the lasing efficiency of a laser manufactured from such crystal.

It has now been found possible to provide a process for making substantially water-free and hydroxyl ion-free laser host garnet crystal material.

A method in accordance with the present invention for making substantially water-free hydroxyl ion-free and $CO_2$-free laser host garnet material comprises:

(i) providing an ambient atmosphere containing less than 10 ppm in the aggregate of water and $CO_2$;

(ii) heating in such atmosphere in a receptacle a charge of oxides in garnet forming proportions, said charge prior to heating containing up to 8% by weight in the aggregate of water and hydroxyl ion impurities, the heating being such that the charge is at a temperature in the range of about 1150 to 1350°C for from about 10 to 20 hours;

(iii) thereafter increasing the heating of said charge in such ambient atmosphere to provide a temperature sufficient to provide a melt of said charge;

(iv) forming in such ambient atmosphere from the melted charge a laser host garnet crystal; and usually

(v) cooling said laser host garnet crystal to room temperature.

In the practice of a particular embodiment of the present invention for the making of Nd:YAG laser host material, separate portions of $Nd_2O_3$, and $Y_2O_3$ commercial grade powders, and $Al_2O_3$ "crackle" (i.e., sapphire) are analyzed to determine the water impurity content (i.e., water+hydroxyl ion) and $CO_2$ content of the respective materials. Customary ranges for water impurity are as follows:

| | |
|---|---|
| $Nd_2O_3$ | 0.8 to 8% by weight |
| $Y_2O_3$ | 0.5 to 0.7% by weight |
| $Al_2O_3$* | nil |

*sapphire fragments ("crackle")

Material from the respective separate proportions are then combined (on a water-free and $CO_2$-free basis) as a charge for the making of Nd:YAG crystal material. The aggregate water impurity in the charge commonly ranges from 1 to 8% by weight. The proportions of the charge are based on the following well known stoichiometry:

$$2.85Y_2O_3+0.15Nd_2O_3+5Al_2O_3\rightarrow 2\{Y_{2.85}Nd_{1.15}\}Al_5O_{12}$$

The charge is placed in a suitable receptacle, i.e., an iridium crucible, which is positioned in a suitable enclosure, e.g., a "bell jar", within which an ambient atmosphere containing less than about 10 ppm of water+$CO_2$ is established. When the Czochralski technique is used the above-noted ambient environment prior to melting of the charge is suitably nitrogen containing about 225 to 1000 ppm $O_2$ and less than 10 ppm $H_2O+CO_2$, and heating means, e.g., an induction coil are provided to heat the charge in the crucible to a temperature in the range of 1150 to 1350°C for from about 10 to 20 hours in the above-noted ambient environment. In the course of this heating period the water impurities and $CO_2$ are substantially removed from the charge. The preferred heating period is about 12 hours; for heating periods of less than 10 hours the water impurities removal is of marginal improvement if at all. Heating periods longer than 20 hours are not considered to provide any further advantage. Following the heating period the temperature of the charge is increased to 1940 to 1966°C to melt the charge while maintaining an ambient environment containing less than 10 ppm of $H_2O$. In practicing the Czochralski technique a Nd:YAG seed rod is immersed in the melt and rotated and progressively raised to "pull" a boule of Nd:YAG crystal from the melt, all the while maintaining an ambient atmosphere environment containing less than 10 ppm of $H_2O$. The boule thus obtained is suitably cooled and thereafter processed to a laser rod using known techniques. It has been found, in accordance with the present invention, that laser rods formed from Nd:YAG crystal prepared as above-described exhibit a ten-fold decrease in water impurity content e.g. to about 1 ppm or less, and also exhibit substantially enhanced lasing efficiency, as compared to Nd:YAG crystal material prepared as above, but without a ten to twenty hour heating period at 1100 to 1350°C prior to melting.

The following example will further illustrate the present invention.

Example

A charge was prepared from commercial grade $Nd_2O_3$ and $Y_2O_3$ powders and $Al_2O_3$ crackle. The water impurity content of the above materials was determined to be

| | |
|---|---|
| $Nd_2O_3$ | 1.18% by weight |
| $Y_2O_3$ | 0.8% by weight |
| $Al_2O_3$ | nil |

A charge was prepared as follows:

| | |
|---|---|
| $Y_2O_3$ | 2101.79 grams |
| $Nd_2O_3$ | 174.23 grams |
| $Al_2O_3$ | 1659.57 grams |

The materials were charged to an iridium crucible located in a "bell jar" which was sealed against atmospheric leaks. A flow 18.9 l/sec (40 CFM) of nitrogen with 800 ppm $O_2$ and less than 10 ppm $H_2O$ and $CO_2$ was used as the ambient atmosphere within the "bell jar". An induction coil was used to heat the charge over a period of 2 hours from room temperature to a temperature in the range of 1235 to 1320°C which was maintained for twelve hours. At the end of the twelve hour period the temperature raised over a period of 5 hours to 1950°C and the charge was melted. A Nd:YAG seed crystal mounted on a rotatable rod was lowered into the melt, rotated at 15 rpm and raised over a period of 46.5 hours to obtain a boule of Nd:YAG crystal 3.8 cm (1-1/2 inch) diameter and 17.8 cm (7 inches) length. A laser rod, 0.6 cm (1/4 inch) diameter, 7.6 cm (3 inches) in length, was manufactured from the boule. The laser rod was analyzed by infra red spectroscopy techniques and water impurity in trace amounts was found which was less than 1/10 of the water impurity content of a laser rod obtained in the same manner except for the heating period prior to melting noted above. The quantum efficiency of the laser rod produced in this example was found to be 93.2% of theoretical lasing efficiency (0.88 at 0.9% Nd) as compared to 76% of theoretical lasing efficiency for a rod prepared in the same manner except for the heating period prior to melting noted above.

While the foregoing description has been particularly directed to Czochralski technique for making Nd:YAG crystal material the present invention is applicable to Bridgman type processes which employ vacuum techniques to establish the ambient environment.

Also the well known laser host garnet crystal materials such as the following can be processed by the pre-melting heat treatment of oxides in accordance with the present invention:

YAG:Er
$YSc_2\ Al_3\ O_{12}$ Nd, Cr
$Gd_3\ Sc_2\ Al_3\ O_{12}$ Nd and/or Cr
$Gd_3\ Sc_2\ Ga_3\ O_{12}$, Cr.

**Claims**

1. A method for making laser host garnet crystal material by melting an oxide charge in garnet forming proportions containing up to 8% by weight in the aggregate of water and hydroxyl ion as impurities, characterised in that, prior to melting, said charge is heated in an ambient atmosphere containing less than

about 10 ppm water and $CO_2$ in the aggregate, for a period of 10 to 20 hours at a temperature in the range of from about 1150°C to 1350°C, and thereafter melting said charge in such ambient atmosphere and a laser host garnet crystal is formed in such ambient atmosphere from the melted charge.

2. A method as claimed in claim 1, characterised in that said ambient atmosphere is nitrogen containing up to 1000 ppm $O_2$ and less than 10 ppm $H_2O+CO_2$.

3. A method as claimed in claim 1 or 2, characterised in that said laser host garnet crystal material is selected from:

Nd:YAG
YAG:Er
$YSc_2\ Al_3\ O_{12}$ Nd, Cr
$Gd_3\ Sc_2\ Al_3\ O_{12}$ Nd and/or Cr
$Gd_3\ Sc_2\ Ga_3\ O_{12}$, Cr.

**Patentansprüche**

1. Verfahren zum Herstellen eines Granatkristall-Lasergrundmaterials durch Schmelzen einer Oxidcharge mit granatbildenden Zusammensetzungsverhältnissen, die zusammen bis zu 8 Gew.-% Wasser und Hydroxylionen als Verunreinigungen enthält, dadurch gekennzeichnet, daß die Charge vor dem Schmelzen für einen Zeitraum von 10 bis 20 Stunden bei einer Temperatur im Bereich von etwa 1150°C bis 1350°C in einer umgebenden Atmosphäre beheizt wird, welche zusammen weniger als ungefähr 10 ppm Wasser und $CO_2$ enthält, und daß danach die Charge in dieser Umgebungsatmosphäre geschmolzen wird und ein Granatkristall-Lasergrundmaterial in dieser Umgebungsatmosphäre aus der Schmelze gebildet wird.

2. Verfahren nach Anspruch 1, dadurch gekennzeichnet, daß die Umgebungsatmosphäre aus Stickstoff besteht, welcher bis zu 1000 ppm $O_2$ und weniger als 10 ppm $H_2O+CO_2$ enthält.

3. Verfahren nach Anspruch 1 oder 2, dadurch gekennzeichnet, daß das Granatkristall-Lasergrundmaterial ausgewählt ist aus:

Nd:YAG
YAG:Er
$YSc_2\ Al_3\ O_{12}$ Nd, Cr
$Gd_3\ Sc_2\ Al_3\ O_{12}$ Nd und/oder Cr
$Gd_3\ Sc_2\ Ga_3\ O_{12}$, Cr.

**Revendications**

1. Procédé de production d'une matière cristalline de grenat-hôte pour laser par fusion d'une charge d'oxydes en des proportions permettant la formation d'un grenat, contenant jusqu'à 8% en poids dans l'agrégat d'eau et d'ions hydroxyle comme impuretés, caractérisé en ce que, avant fusion, ladite charge est chauffée dans une atmosphère ambiante contenant moins d'environ 10 ppm d'eau et de $CO_2$ dans l'agrégat, pendant un temps de 10 à 20 heures à une température comprise dans l'intervalle d'environ 1150°C à 1350°C, puis ladite charge est fondue dans cette atmosphère ambiante et un cristal de grenat-hôte pour laser est formé dans cette atmosphère ambiante à partir de la charge fondue.

2. Procédé suivant la revendication 1, caractérisé en ce que l'atmosphère ambiante est de l'azote contenant jusqu'à 1000 ppm de $O_2$ et moins de 10 ppm de $H_2O+CO_2$.

3. Procédé suivant la revendication 1 ou 2, caractérisé en ce que la matière cristalline de grenat-hôte pour laser est choisie entre:

Nd:YAG
YAG:Er
$YSc_2\ Al_3\ O_{12}$ Nd, Cr
$Gd_3\ Sc_2\ Al_3\ O_{12}$ Nd et/ou Cr
$Gd_3\ Sc_2\ Ga_3\ O_{12}$, Cr.